Europäisches Patentamt

European Patent Office

Office européen des brevets

(19)

(11) Veröffentlichungsnummer: **0 058 243**
**B1**

(12)
# EUROPÄISCHE PATENTSCHRIFT

(45) Veröffentlichungstag der Patentschrift:
10.07.85

(51) Int. Cl.⁴: **H 03 K 5/01**, G 11 C 7/06

(21) Anmeldenummer: **81109280.8**

(22) Anmeldetag: **29.10.81**

(54) **Integrierte digitale Halbleiterschaltung.**

(30) Priorität: **12.02.81 DE 3105147**

(43) Veröffentlichungstag der Anmeldung:
**25.08.82 Patentblatt 82/34**

(45) Bekanntmachung des Hinweises auf die Patenterteilung:
**10.07.85 Patentblatt 85/28**

(84) Benannte Vertragsstaaten:
**DE FR GB**

(56) Entgegenhaltungen:
**EP - A - 0 005 743**
**EP - A - 0 030 813**
**DE - A - 2 828 822**
**US - A - 3 646 369**
**US - A - 3 805 095**

**Patent Abstracts of Japan Band 5, Nr. 7, 17. Januar 1981**

(73) Patentinhaber: **Siemens Aktiengesellschaft, Berlin und München Wittelsbacherplatz 2, D-8000 München 2 (DE)**

(72) Erfinder: **Frieling, Focko, Hohenschwangauplatz 32, D-8000 München 90 (DE)**
Erfinder: **Michael, Ewald, Dipl.-Phys., Jagdfeldring 87, D-8013 Haar (DE)**
Erfinder: **Nikutta, Wolfgang, Dipl.-Phys., Werinherstrasse 101, D-8000 München 90 (DE)**

**Beschreibung**

Die Erfindung bezieht sich auf eine integrierte digitale Halbleiterschaltung nach dem Oberbegriff des Patentanspruches 1.

In der DE-OS 2 828 822 (VPA 78 P 1112) ist eine digitale Halbleiterschaltung aus mindestens zwei Schaltungsteilen mit jeweils einer der Aufnahme bzw. Übertragung von Digitalinformation dienenden Kette aus jeweils gleichen Speicherzellen beschrieben, bei der die Ketten von Speicherzellen von einem gemeinsamen Taktgeber gesteuert sind. Bei dieser Halbleiterschaltung ist vorgesehen, daß die Kette von Speicherzellen eines ersten Schaltungsteils mit einem bei Anregung jeweils einen Digitalimpuls emittierenden Signalgeber derart gekoppelt ist, daß der Signalgeber mit dem Erreichen eines vorgegebenen bestimmten Digitalzustandes seiner Kette von Speicherzellen einen Digitalimpuls emittiert, daß ferner eine Amplitudenmodulation der vom gemeinsamen Taktgeber erzeugten Folge von Taktsignalen durch den vom Signalgeber emittierten Digitalimpuls gegeben ist, und daß schließlich das auf diese Weise modulierte Taktsignal dem zweiten Schaltungsteil über eine auf die Modulation ansprechende und bei deren Vorhandensein den digitalen Betriebszustand der Kette von Speicherzellen des zweiten Schaltungsteils korrigierenden Signalerkennungsschaltung zugeführt ist.

Ersichtlich treten bei einer solchen Schaltung neben Impulsen mit dem logischen Hub von »0« auf »1« auch Synchronisierungsimpulse mit überhöhten Amplituden auf, die mittels der genannten Signalerkennungsanlage festgestellt werden.

Desweiteren ist aus der JP-A-55-136 723 eine einfache digitale Halbleiterschaltung bekannt, die von einem nicht dargestellten Schaltungsteil erzeugte Impulse üblicher Amplitudenhöhe mit einer Amplitudenüberhöhung beaufschlagt. Diese, durch die Halbleiterschaltung in ihrer Amplitudenhöhe modifizierten Impulse, werden dann einem weiteren Schaltungsteil, dargestellt durch einen Ladekondensator, zugeführt.

Bei der Adressierung von dynamischen digitalen Halbleiterspeichern mit Ein-Transistor-Speicherzellen vom MOS-Typ hat man zur Adressierung der einzelnen in Form einer Matrix an der Oberfläche des den Speicher aufnehmenden Siliciumchips angeordneten Speicherelemente sowohl den einzelnen Zeilen zugeordnete Wortleitungen als auch den einzelnen Spalten zugeordnete Bitleitungen. Während man nun die einzelnen — aus je einem Transfertransistor und je einer mit diesem in Reihe liegenden Speicherkapazität bestehenden — Speicherzellen an die Bitleitung über den Drain des jeweiligen Transfertransistors an die zugehörige Bitleitung anschließt, erfolgt der Anschluß der einzelnen Speicherzellen an die zugehörige Wortleitung über das Gate des zugehörigen Transfer-MOS-Feldeffekttransistors der Speicherzellen. Es ist deshalb für eine rasche wirkungsvolle Adressierung eine rasche und möglichst vollständige Erzeugung des den Pegel logisch »1« definierenden Ladezustandes der jeweils adressierten Wortleitung bzw. Bitleitung erwünscht. Es erscheint deshalb zweckmäßig, wenn man die Adressierung mit überhöhten Ladeimpulsen als Adressiersignal vornimmt. Aber auch in anderen Fällen kann das Vorhandensein von Steuerimpulsen mit gegenüber den sonst in der Schaltung verwendeten Digitalimpulsen überhöhter Amplitude bei digitalen MOS-Halbleiterschaltungen zweckmäßig sein, weil auch dann — entweder im Interesse der Erkennung oder im Interesse einer höheren Ladegeschwindigkeit — Vorteile gegenüber den üblichen Schaltungen erreichbar sind.

Aufgabe der Erfindung ist es deshalb, eine mit geringem Aufwand realisierbare Möglichkeit zur Überhöhung solcher Lade- bzw. Adressierimpulse anzugeben, die sich vor allem für die Verwendung in dynamischen digitalen MOS-Halbleiterschaltungen, insbesondere auch für dynamische RAM-Speicher eignet.

Diese Aufgabe wird bei einer Halbleiterschaltung der eingangs genannten Art durch die Merkmale des kennzeichnenden Teils des Patentanspruchs 1 gelöst.

Weiterbildungen der Erfindung sind in den abhängigen Ansprüchen gekennzeichnet.

Die Erfindung wird nun anhand der Fig. 1 bis 5 näher beschrieben. Dabei stellt

Fig. 1 eine einfache,

Fig. 2 eine verbesserte und

Fig. 3 eine erfindungsgemäße Ausgestaltung einer Schaltung zur Erzeugung von überhöhten Ladeimpulsen dar, während in

Fig. 4 das Zeitdiagramm der zu verwendenden Digitalimpulse einschließlich des für den Eingang des zweiten Schaltungsteils resultierenden Impulses gezeigt ist.

In Fig. 5 ist eine Möglichkeit für die Erzeugung der für die Steuerung der Schaltung benötigten Impulse $0_1$, $0_2$ und $0_3$ angegeben. Zunächst soll die in Fig. 1 bzw. Fig. 2 gezeigte Halbleiterschaltung näher betrachtet werden.

Ein die zu überhöhenden Impulse $0_0$ liefernder erster Schaltungsteil S1 ist mit dem die Impulse $0_0$ liefernden Ausgang mit einem Eingang eines zweiten Schaltungsteiles S2 verbunden, der für die Steuerung durch diese Impulse $0_0$ vorgesehen ist. Beispielsweise ist der erste Schaltungsteil S1 durch einen Adressierdekoder und der zweite Schaltungsteil S2 durch eine zu adressierende Wortleitung eines dynamischen RAM-Speichers gegeben. Ein erster MOS-Feldeffekttransistor T1 liegt mit seinem Drain an der den Impuls $0_0$ führenden Verbindungsleitung zwischen dem ersten Schaltungsteil S1 und dem zweiten Schaltungsteil S2. Ein zweiter MOS-Feldeffekttransistor T2 vom selben Typ ist ebenfalls mit seinem Drain an den Steuereingang des Schaltungsteils S2 und damit an den Drain des ersten MOS-Transistors T1 gelegt. Das Gate des ersten MOS-Transistors T1 liegt an einem Versorgungspotential $V_{CC}$, das auch für die beiden Schaltungsteile S1 und S2 verbindlich ist und dort entsprechend der schaltungsmäßigen Ausbildung dieser beiden Schaltungsteile eingesetzt ist. Als Bezugspotential dient das Potential $V_{ss}$, das an Masse gelegt ist und auf welches die anzuwendenden Steuerimpulse — und damit auch der von S1 gelieferte Impuls $0_0$ — bezogen sind. Das Gate des zweiten MOS-Transistors T2 ist mit dem Sourceanschluß des ersten MOS-Transistors T1 verbunden.

Die beiden vorgesehenen Kondensatoren C1 und C2 liegen an je einem Anschluß eines als weitere Impulsversorgungsquelle dienenden dritten Schaltungsteiles S3, der seinerseits mittels des zu überhöhenden Impulses $0_0$, d. h. also durch den Signalausgang des ersten Schaltungsteiles S1 gesteuert ist. Dieser dritte Schaltungsteil S3 liefert an einem ersten Ausgang auf jeden Impuls $0_0$ je einen ersten Impuls $0_1$ an den ersten Kondensator C1 und damit an die Source des MOS-Transistors T1 sowie an das Gate des MOS-Transistors T2 unter Vermittlung des ersten Kondensators C1. Außerdem liefert der dritte Schaltungsteil S3 an einem zweiten Ausgang auf jeden Impuls $0_0$ je einem Impuls $0_2$, der über den zweiten Kondensator C2 an den Sourceanschluß des zweiten MOS-Transistors T2 und an den Sourceanschluß eines dritten MOS-Transistors T3 vom selben Typ wie T1 und T2 gelegt ist. Der Drainanschluß und der Gateanschluß des dritten MOS-Feldeffekttransistors T3 liegen zusammen am Versorgungspotential $V_{CC}$. Um die angestrebte Wirkung zu erhalten, ist es erforderlich, daß das zur Steuerung der drei MOS-Transistoren T1, T2 und T3 vorgesehene Betriebspotential nicht das an Masse liegende Bezugspotential ($V_{ss}$) ist.

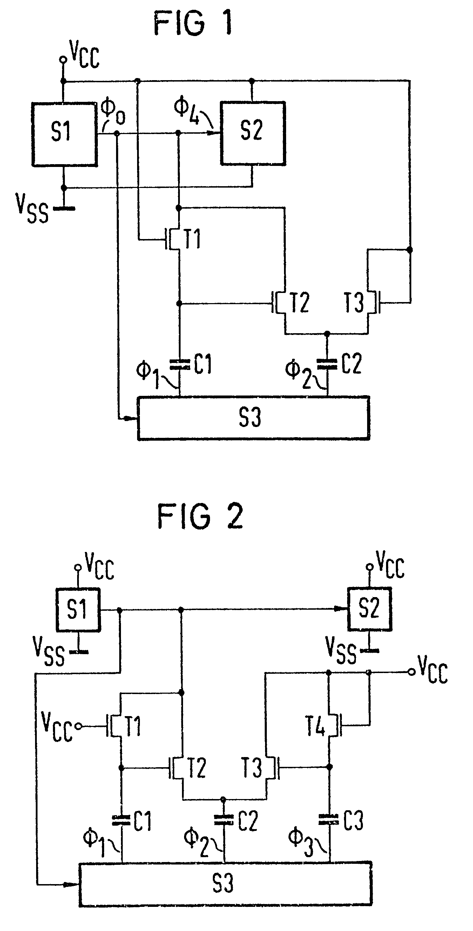

Bei der in Fig 2 dargestellten Ausführung ist neben den bereits genannten und aus Fig. 1 ersichtlichen Schaltungsteilen noch ein vierter Kondensator C3 und ein vierter MOS-Transistor T4 vorgesehen. Dabei ist der vierte Kondensator C3 an einen Ausgang des dritten Schaltungsteiles S3 gelegt, der einen noch zu definierenden Impuls $0_3$ unter Vermittlung dieses vierten Kondensators C3 sowohl an den Sourceanschluß des vierten MOS-Transistors T4 als auch — in Abweichung zu der Schaltung gemäß Fig. 1 — an das Gate des dritten MOS-Transistors T3 gibt. Außerdem sind Gate und Drain des vierten MOS-Transistors T4 zusammen mit dem Drain des dritten MOS-Transistors T3 an das Versorgungspotential $V_{CC}$ gelegt.

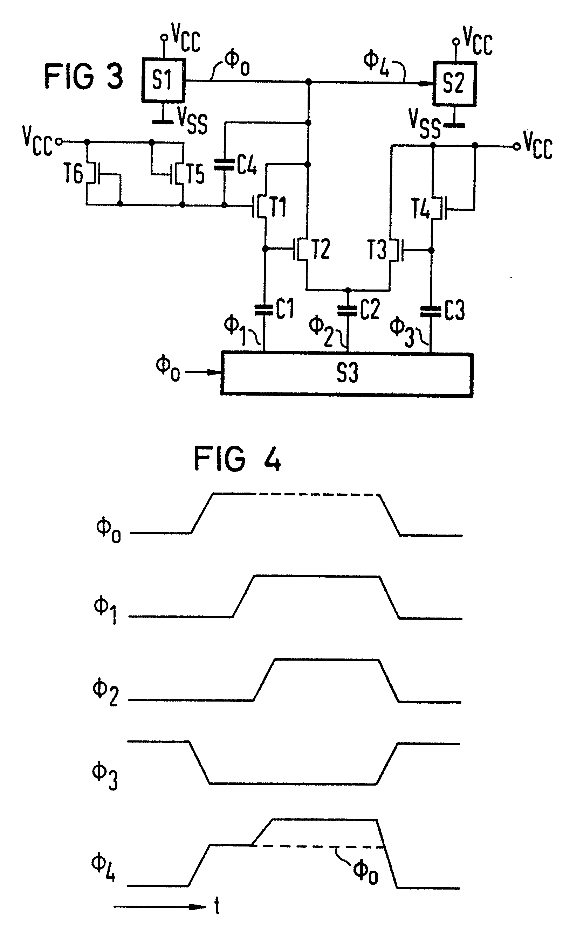

Das zeitliche Verhalten der Impulse $0_0$, $0_1$, $0_2$ und $0_3$ sowie des durch deren Zusammenwirken am Eingang des zweiten Schaltungsteils S2 gebildeten Impulses $0_4$ ist in Fig. 4 dargestellt.

Zunächst wird auf die Funktion einer Schaltung gemäß Fig. 2 eingegangen, aus der sich dann die Wirkungsweise der vereinfachten Ausgestaltung gemäß Fig. 1 unmittelbar ergibt. Zu erwähnen ist noch, daß die verwendeten MOS-Transistoren vom selben Kanaltyp und selbstsperrend sind.

Wie aus Fig. 4 ersichtlich ist, liegt die steigende Flanke des Impulses $0_1$ zeitlich nach der steigenden Flanke des Auslöseimpulses $0_0$ und bevorzugt zeitlich vor der steigenden Flanke des Impulses $0_2$, während die fallenden Flanken dieser Impulse zeitlich zusammenfallen. Ferner ist der an den vierten Kondensator C3 zu legende Impuls $0_3$ — wenigstens was dessen fallende Flanke betrifft — zu dem vom ersten Schaltungsteil S1 gelieferten Steuerimpuls $0_0$ invertiert.

Das aus Fig. 4 ersichtliche zeitliche Verhalten der für die Steuerung einer Schaltung gemäß Fig. 2 zu verwendenden Steuerimpulse führt nun bei der in Fig. 2 dargestellten Schaltung zu folgendem Verhalten:

Unmittelbar vor dem Einsetzen der aktiven Betriebsphase der Schaltung wird der über den vierten Kondensator C3 das Gate des dritten MOS-Transistor T3 beaufschlagende Impuls $0_3$ abgeschaltet. Dies geschieht zu dem Zweck, einen Ladungsverlust durch den Vorladetransistor T3 während der Überhöhungsphase des in Kombination vom ersten Schaltungsteil S1 und dem aus den Transistoren T1 und T2 sowie den Kondensatoren C1 und C2 bestehenden Schaltungsteil gelieferten Impulses $0_4$ zu vermeiden. Mit dem Auftreten des Impulses $0_0$ und damit der Anfangsphase des Impulses $0_4$ wird der erste Kondensator C1 über den ersten Transistor T1 aufgeladen. Um die Erhöhung des an den Eingang des zweiten Schaltungsteils S2 gelangenden Impulses $0_4$ mit dem Nachschiebeimpuls $0_2$ zu synchronisieren, wird das Gate des zweiten MOS-Transistors T2 bereits vorher über eine Bootstrap-Kapazität, d. h. über den ersten Kondensator C1 mit dem Impuls $0_1$ versorgt.

In der Zeit zwischen dem Auftreten des ersten, am Kondensator C1 liegenden Impulses $0_1$ und dem Auftreten des zweiten, am Kondensator C2 anliegenden Impulses $0_2$ wird der Drainanschluß der beiden MOS-Transistoren T1 und T2 potentialmäßig gegenüber dem Impuls $0_0$ bereits leicht erhöht. Mit dem Auftreten der steigenden Flanke des über den zweiten Kondensator C2 zugeführten Impulses $0_2$ erfolgt aufgrund der Wirkung dieses Impulses die angestrebte Überhöhung des dem Eingang des zweiten Schaltungsteiles S2 zugeführten Impulssignals $0_4$.

Nach dem Ende der aktiven Phase wird der über den vierten Kondensator C3 anhängige Vorladeimpuls $0_3$ wieder eingeschaltet, wodurch die Gatespannung am dritten MOS-Transistor T3 erhöht wird. Damit kann der zweite Kondensator C2 wieder auf das Versorgungspotential $V_{CC}$ vorgeladen werden.

Mit dem Auftreten des nächsten vom ersten Schaltungsteil S1 gelieferten Impulses $0_0$ wiederholt sich der beschriebene Vorgang.

Bei der vereinfachten Ausgestaltung gemäß Fig. 1 hat man trotz des Fehlens des vierten Kondensators C3 und des Impulses $0_3$ dieselbe Wirkung. Der dritte MOS-Transistor T3 bewirkt eine Vorladung des zweiten Kondensators C2 auf das Potential $V_{CC}-U_T$, wobei $U_T$ die Schwellspan-

nung des Transistors T3 bedeutet. Diese Spannung bleibt ausschließlich für den bei der Überhöhung erreichten Maximalwert für die Amplitude des an den Eingang des zweiten Schaltungsteils S2 gelangenden Impulses $0_4$ verbindlich.

Bei der in Fig. 2 dargestellten Schaltung wird jedoch infolge der Anwesenheit des vierten Kondensators C3 und des vierten MOS-Transistors T4 ein noch höherer Wert für die Amplitude des an den Eingang des zweiten Schaltungsteils S2 gelangenden Impulses $0_4$ erreicht, als dies im Falle der einfacheren Ausgestaltung gemäß Fig. 1 möglich ist.

Im Vergleich zu anderen Möglichkeiten für die Erzielung einer Überhöhung von Steuerimpulsen wird aufgrund der oben beschriebenen Maßnahme der die Impulse $0_0$ liefernde erste Schaltungsteil S1 nicht durch den die Überhöhung bewirkenden Nachschiebeeffekt belastet, was sich in einer steileren Anstiegsflanke des an den zweiten Schaltungsteil S2 gelangenden Impulses $0_4$ und in einer Verminderung der zwangsläufig bei solchen Impuls-Überhöhungsschaltungen auftretenden Stromspitzen vorteilhaft bemerkbar macht. Außerdem wird bei Verwendung der in Fig. 2 dargestellten Variante der Kondensator C2 auf den vollen $V_{CC}$-Pegel aufgeladen, was zu einer verbesserten Amplitudenüberhöhung des an den zweiten Schaltungsteil S2 zu übertragenden Steuerimpulses $0_4$ führt.

Die in Fig. 1 und in Fig. 2 dargestellten Schaltungen können noch vereinfacht werden, indem man den für die Steuerung des ersten Kondensators C1 maßgebenden Impuls $0_1$ auch an den zweiten Kondensator C2 legt. Damit entfällt die Erzeugung der zweiten Impulse $0_2$.

Andererseits tritt aber hierdurch im Bereich des zu überhöhenden Teiles des Impulses $0_4$ eine geringere Flankensteilheit auf.

Bei der praktischen Realisierung der Schaltung in monolithischer Zusammenfassung mit den Schaltungsteilen S1, S2 und S3 sowie weiterer, den eigentlichen Kern der integrierten Schaltung bildender Schaltungsteil, z. B. der Matrix eines dynamischen RAM-Speichers, werden die Kondensatoren C1, C2 usw. zweckmäßig als MOS-Kondensatoren in bekannter Weise ausgeführt. Die Verwendung von aus dotiertem polykristallinem Silicium bestehenden Gateelektroden bei MOS-Transistoren vom Anreicherungstyp, also selbstsperrenden MOS-Transistoren, führt bekanntlich zu einer Verminderung der Einsatzspannung $U_T$. Aus diesem Grund und auch aus weiteren Gründen ist es vor allem bei Verwendung einer Schaltung gemäß Fig. 1 zweckmäßig, wenn man die verwendeten Transistoren in Silicon-Gate-Technologie realisiert.

Die in Fig. 1 bzw. Fig. 2 dargestellte Schaltung zur Erzielung von Impulsen mit überhöhter Amplitude läßt sich erfindungsgemäß in der aus Fig. 3 ersichtlichen Weise hinsichtlich der Gatesteuerung des ersten MOS-Feldeffekttransistors T1 ergänzen. Wie aus Fig. 3 ersichtlich ist, liegt dann das Versorgungspotential $V_{CC}$ nicht unmittelbar, sondern unter Vermittlung zweier weiterer MOS-Feldeffekttransistoren T5 und T6 vom gleichen Typ wie die bisher eingeführten MOS-Transistoren am Gate des ersten MOS-Transistors T1 der Schaltung. Dabei sind das Gate und der Drain des Transistors T5 sowie der Drain des Transistors T6 mit einem am Versorgungspotential $V_{CC}$ liegenden Versorgungsanschluß unmittelbar verbunden, während die Sourceanschlüsse der beiden MOS-Transistoren T5 und T6 und das Gate des Transistors T6 an das Gate des ersten MOS-Transistors T1 gelegt sind. Außerdem ist das Gate des ersten Transistors T1 mit dessen Drainanschluß und damit dem Ausgang des erfindungsgemäßen Schaltungsteils über einen dritten Kondensator C4 verbunden.

Infolge der Anwesenheit der soeben beschriebenen Steuerschaltung für das Gate des ersten MOS-Transistors T1 der erfindungsgemäßen Nachschiebeschaltung wird diese gegen prozeßbedingte Schwankungen der Einsatzspannung der Transistoren praktisch unempfindlich. Eine Vergrößerung der Einsatzspannung $U_T$ bewirkt nämlich über die Kopplung der ersten Flanke des zu erzeugenden Impulses $0_4$ eine Erhöhung der Vorladung des Gates des ersten MOS-Feldeffekttransistors T1 unter Vermittlung des dritten Kondensators C4, da der Transistor T5 die effektive Ladespannung auf $V_{CC} + U_T$ begrenzt. Dadurch wird der erste Kondensator C1 stärker vorgeladen und damit das Gate des zweiten MOS-Transistors T2 der Schaltung in der Nachschiebephase stärker gebootstrapt.

Der für die Erzeugung des Steuerimpulses $0_0$ zuständige erste Schaltungsteil S1, der durch den überhöhten und aufgrund der erfindungsgemäßen Schaltung erhaltenen Impuls $0_4$ zu beaufschlagende zweite Schaltungsteil S2 sind für die Erfindung nicht von unmittelbarer Bedeutung, so daß Details in dieser Beziehung nicht erforderlich sind.

Hat man die Erfindung für einen dynamischen Speicher der eingangs angegebenen Bauart vorgesehen, so kann z. B. der zweite Schaltungsteil S2 durch je eine Wortleitung eines dynamischen MOS-Halbleiterspeichers gegeben sein, die dann mit den jeweils zugehörigen Speicherzellen ausschließlich über Gateelektroden, also kapazitiv, gekoppelt ist. Im Interesse eines höheren Zellpegels erscheint dann der von dem erfindungsgemäßen Schaltungsteil gelieferte überhöhte Impuls $0_4$ durchaus angebracht. Der erfindungsgemäße Schaltungsteil kann z. B. dem die Impulse $0_0$ liefernden Ausgang des ersten Schaltungsteils S1 fest zugeordnet sein und zusammen mit diesem bei Bedarf an den jeweiligen Verbraucher S2 angeschaltet werden. In anderen Fällen kann es statt dessen günstiger sein, dem Verbraucher S2 einen solchen Schaltungsteil zuzuordnen, z. B. dann, wenn die Impulse $0_0$ von mehreren Impulsquellen S1 geliefert werden.

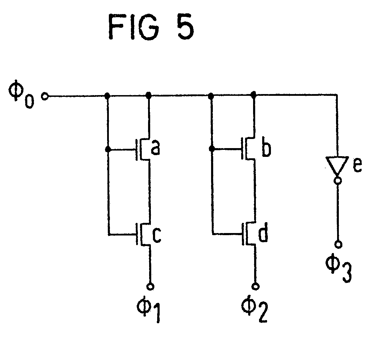

Auch der dritte Schaltungsteil S3 kann in konventioneller Weise ausgestaltet sein. Um ein Beispiel für einen solchen Schaltungsteil zu geben, der für die Steuerung einer Schaltung gemäß Fig. 1, Fig. 2 oder Fig. 3 geeignet ist, wird auf Fig. 5 hingewiesen.

Bei der in Fig. 5 gezeigten Ausführung für den Schaltungsteil S3 hat man zur Erzeugung der Impulse $0_1$ die Serienschaltung zweier selbstsperrender MOS-Feldeffekttransistoren a und c vom selben Typ und für die Erzeugung der Impulse $0_2$ eine entsprechende Kombination zweier weiterer MOS-Transistoren b und d.

Zur Erzeugung der Impulse $0_1$ sind die vom Schaltungsteil S1 gelieferten Impulse $0_0$ an das Gate der beiden bezüglich ihrer Source-Drainstrecken in Reihe liegenden MOS-Transistoren a und c gelegt, wobei der Drain des ersten Transistors a ebenfalls durch diese Impulse $0_0$ gesteuert ist. An der Source des Transistors c ist dann der Impuls $0_1$ abnehmbar. Die zur Erzeugung der Impulse $0_2$ dienende Anordnung der beiden MOS-Transistoren b und d entspricht vollständig der Schaltung der Transistoren a und b. Das gewünschte Signal $0_2$ ist an der Source des Transistors d abzunehmen, während das Gate der beiden Transistoren b und d sowie der Drain des Transistors b am Impuls $0_0$ liegen. Um das aus Fig. 4 ersichtliche zeitliche Verhalten der Anstiegsflanke des Impulses $0_2$ in bezug auf die zugehörigen Impulse $0_0$ und $0_1$ zu erhalten ist der Abstand zwischen Source und Drain beim Transistor a kleiner als beim Transistor b, während die beiden Transistoren c und d übereinstimmende Kanallängen und damit — im Gegensatz zu den Transistoren a und b — exakt übereinstimmende und kurze Laufzeiten aufweisen. Zur Erzeugung der für die Steuerung des dritten Kondensators C3 vorgesehenen Impulse $0_3$ ist ein Inverter e vorgesehen, dessen Eingang durch den Impuls $0_0$ gesteuert ist und dessen Ausgang die Impulse $0_3$ liefert.

Bei der Ausführung des Schaltungsteils S3 gemäß Fig. 5 wird das zeitliche Verhalten der zu erzeugenden Impulse $0_1$ und $0_2$ durch unterschiedliche Laufzeiten der Transistoren a und b bedingt.

**Patentansprüche**

1. Integrierte digitale MOS-Halbleiterschaltung mit einem als Impulsgenerator dienenden ersten Schaltungsteil (S1) und einem zweiten Schaltungsteil (S2), dessen Eingang durch die vom ersten Schaltungsteil (S1) gelieferten Impulse ($0_0$) gesteuert und zugleich über die Source-Drainstrecke eines ersten Transistors (T1) an den einen Anschluß eines ersten Kondensators (C1) und weiterhin über einen zweiten Transistor (T2) an den einen Anschluß eines zweiten Kondensators (C2) gelegt ist, der zugleich über einen dritten Transistor (T3) mit dem Versorgungspotential (V$_{CC}$) verbunden ist, das zugleich zusammen mit einem Bezugspotential (V$_{SS}$) für die Versorgung des ersten Schaltungsteils (S1) und des zweiten Schaltungsteils (S2) zuständig ist, bei der außerdem das Gate des ersten Transistors (T1) vom Versorgungspotential (V$_{CC}$) her gesteuert und das Gate des zweiten Transistors (T2) mit dem am ersten Kondensator (C1) liegenden Anschluß des ersten Transistors (T1) verbunden ist, bei der ferner die beteiligten Transistoren (T1, T2, T3) selbstsperrende MOS-Feldeffektransistoren sind und bei der schließlich die anderen Anschlüsse des ersten Kondensators (C1) und des zweiten Kondensators (C2) jeweils durch Digitalimpulse ($0_1$, $0_2$) beaufschlagt sind, derart, daß der am ersten Kondensator (C1) liegende Impuls ($0_1$) und der am zweiten Kondensator (C2) liegende Impuls ($0_2$) gleichzeitig mit dem vom ersten Schaltungsteil (S1) gelieferten Impuls ($0_0$) enden, während der Beginn des vom ersten Schaltungsteil (S1) abgegebenen Impulses ($0_0$) zeitlich vor dem Beginn der an die beiden Kondensatoren (C1, C2) zu legenden Impulse ($0_1$, $0_2$) stattfindet und der Beginn des an den zweiten Kondensator (C2) zu legenden Impulses ($0_2$) nicht vor dem Beginn des an den ersten Kondensator (C1) zu legenden Impulses ($0_1$) stattfindet, dadurch gekennzeichnet, daß das Gate des ersten Transistors (T1) durch das Versorgungspotential (V$_{CC}$) unter Vermittlung zweier weiterer Transistoren (T5, T6) vom Typ der bisher genannten Transistoren (T1–T3) gesteuert wird, daß dabei zwischen dem Gate und dem Drain des ersten Transistors (T1) ein dritter Kondensator (C4) vorgesehen ist, und daß schließlich das Gate des ersten Transistors (T1) mit den Sourceanschlüssen der beiden Vermittlungstransistoren (T5, T6) sowie mit dem Gate von einem Vermittlungstransistor (T6) verbunden ist, während die restlichen Anschlüsse der beiden Vermittlungstransistoren (T5, T6) am Versorgungspotential (V$_{CC}$) liegen.

2. Halbleiterschaltung nach Anspruch 1, dadurch gekennzeichnet, daß der dritte Transistor (T3) mit seinem Gate und mit seinem Drain unmittelbar an das Versorgungspotential (V$_{CC}$) gelegt und auf diese Weise eine Funktion des dritten Transistors (T3) als Widerstand erreicht ist.

3. Halbleiterschaltung nach Anspruch 1, dadurch gekennzeichnet, daß ein vierter Kondensator (C3) und ein vierter Transistor (T4) vom Typ der bisher genannten Transistoren vorgesehen sind und daß dabei das Gate und der Drain dieses vierten Transistors (T4) mit dem Drain des dritten Transistors (T3) verbunden ist, während der Sourceanschluß des vierten Transistors (T4) einerseits am Gate des dritten Transistors (T3) und andererseits an dem einen Anschluß des vierten Kondensators (C3) liegt, während der andere Anschluß dieses Kondensators durch ein Vorladesignal ($0_3$) beaufschlagt ist, welches mit den vom ersten Schaltungsteil (S1) gelieferten Impulsen ($0_0$) nicht koinzidiert.

**Claims**

1. An integrated digital MOS-semiconductor circuit having a first circuit component (S1) serving as a pulse generator, and a second circuit component (S2) the input of which is controlled by pulses ($0_0$) supplied by the first circuit component (S1) and which is, at the same time, connected via the source-drain path of a first transistor (T1) to one terminal of a first capacitor (C1), and is also connected via a second transistor (T2) to one terminal of a second capacitor (C2) which is at the same time connected via a third transistor (T3) to the supply potential ($V_{CC}$) which, together with a reference potential ($V_{SS}$), is responsible at the same time for the supply of the first circuit component (S1) and the second circuit component (S2), in which the gate of the first transistor (T1) is controlled by the supply potential ($V_{CC}$) and the gate of the second transistor (T2) is connected to that terminal of the first transistor (T1) which is connected to the first capacitor (C1), in which the participating transistors (T1, T2, T3) are self-blocking MOS-field effect transistors, and in which, finally, the other terminals of the first capacitor (C1) and the second capacitor (C2) are each supplied digital pulses ($0_1$, $0_2$) in such a way that the pulse ($0_1$) applied to the first capacitor (C1) and the pulse ($0_2$) applied to the second capacitor (C2) terminate simultaneously with the pulse ($0_0$) supplied by the first circuit component (S1), whilst the start of the pulse ($0_0$) emitted by the first circuit component (S1) takes place before the start of the pulses ($0_1$, $0_2$) which are to be applied to the two capacitors (C1, C2), and the start of the pulse ($0_2$) which is to be applied to the second capacitor (C2) does not take place before the beginning of the pulse ($0_1$) which is to be applied to the first capacitor (C1), characterised in that the gate of the first transistor (T1) is controlled by the supply potential ($V_{CC}$) by way of two further transistors (T5, T6) of the type of the previously-mentioned transistors (T1—T3); that between the gate and the drain of the first transistor (T1) there is arranged a third capacitor (C4); and that, finally, the gate of the first transistor (T1) is connected to the source terminals of the two intermediate transistors (T5, T6) and to the gate of one intermediate transistor (T6), whilst the remaining terminals of the two intermediate transistors (T5, T6) are connected to the supply potential ($V_{CC}$).

2. A semiconductor circuit as claimed in claim 1, characterised in that the third transistor (T3) is directly connected to the supply potential ($V_{CC}$) at its gate and at its drain and, in this way, a function of the third transistor (T3) as resistance is achieved.

3. A semiconductor circuit as claimed in claim 1, characterised in that a fourth capacitor (C3) and a fourth transistor (T4) of the type of the previously-mentioned transistors, are provided, and that in this case the gate and the drain of this fourth transistor (T4) are connected to the drain of the third transistor (T3), whilst the source terminal of the fourth transistor (T4) is connected, on the one hand, to the gate of the third transistor (T3) and, on the other hand, to one terminal of the fourth capacitor (C3), whilst the other terminal of this capacitor is supplied with a pre-load signal ($0_3$) which does not coincide with the pulses ($0_0$) supplied by the first circuit component (S1).

**Revendications**

1. Circuit intégré numérique à semi-conducteurs MOS, comprenant une première partie de circuit (S1) servant de générateur d'impulsions et une deuxième partie de circuit (S2), dont l'entrée est commandée par des impulsions ($0_0$) fournies par la première partie de circuit (S1) et qui est reliée en même temps à travers le circuit source-drain d'un premier transistor (T1) à l'une des bornes d'un premier condensateur (C1) et à travers un second transistor (T2) à l'une des bornes d'un second condensateur (C2), lequel est relié en même temps à traverse un troisième transistor (T3) au potentiel d'alimentation ($V_{CC}$) qui est chargé ensemble avec un potentiel de référence ($V_{SS}$) de l'alimentation de la première partie de circuit (S1) et de la seconde partie de circuit (S2), où, en outre, la grille du premier transistor (T1) est commandée à partir du potentiel d'alimentation ($V_{CC}$) et la grille du second transistor (T2) est reliée à la borne du premier transistor (T1) connectée au premier condensateur (C1), où, de plus, les transistors concernés (T1, T2, T3) sont des transistors à effet de champ MOS à autoblocage et où, enfin, les autres bornes du premier condensateur (C1) et du second condensateur (C2) sont attaquées par des impulsions numériques ($0_1$, $0_2$), de manière que l'impulsion ($0_1$) appliquée au premier condensateur (C1) et l'impulsion ($0_2$) appliquée au second condensateur (C2) se terminent en même temps que l'impulsion ($0_0$) fournie par la première partie de circuit (S1), tandis que le début de l'impulsion ($0_0$) délivrée par la première partie de circuit (S1) a lieu chronologiquement avant le début des impulsions ($0_1$, $0_2$) à appliquer aux deux condensateurs (C1, C2) et le début de l'impulsion ($0_2$) à appliquer au second condensateur (C2) n'a pas lieu avant le début de l'impulsions ($0_1$) à appliquer au premier condensateur (C1), caractérisé en ce que la grille du premier transistor (T1) est commandée par le potentiel d'alimentation ($V_{CC}$) à travers deux autres transistors (T5, T6), du type des transistors (T1—T3) mentionnés jusqu'ici, qu'un troisième condensateur (C4) est prévu entre la grille et le drain du premier transistor (T1) et que, enfin, la grille du premier transistor (T1) est reliée au bornes de source des deux autres transistors intermédiaires (T5, T6) et à la grille de l'un (T6) de ces transistors intermédiaire, tandis que les bornes restantes des deux transistors intermédiaires (T5, T6) sont au potentiel d'alimentation ($V_{CC}$).

2. Circuit à semi-conducteurs selon la revendication 1, caractérisé en ce que la troisième transistor (T3) est relié directement au potentiel d'alimentation ($V_{CC}$) par sa grille et par son drain, de sorte que le troisième transistor (T3) agit à la façon d'une résistance.

3. Circuit à semi-conducteurs selon la revendication 1, caractérisé en ce qu'un quatrième condensateur (C3) et un quatrième transistor (T4) du type des transistors mentionnés jusqu'ici sont prévus et en ce que la grille et le drain de ce quatrième transistor (T4) sont connectés au drain du troisième transistor (T3), tandis que la borne de source du quatrième transistor (T4) est connectée d'une part à la grille du troisième transistor (T3) et d'autre part à l'une des bornes du quatrième condensator (C3), l'autre borne de ce condensateur étant attaquée par un signal de précharge ($0_3$) qui ne coïncide pas avec les impulsions ($0_0$) fournies par la première partie de circuit (S1).

# FIG 1

# FIG 2

FIG 3

FIG 4

# FIG 5